(19) Europäisches Patentamt
European Patent Office
Office européen des brevets

(11) EP 4 332 589 A1

(12) **EUROPEAN PATENT APPLICATION**
published in accordance with Art. 153(4) EPC

(43) Date of publication:
06.03.2024 Bulletin 2024/10

(21) Application number: 22795543.2

(22) Date of filing: 07.04.2022

(51) International Patent Classification (IPC):
**G01R 29/08** (2006.01)

(52) Cooperative Patent Classification (CPC):
**G01R 29/08**

(86) International application number:
**PCT/JP2022/017225**

(87) International publication number:
**WO 2022/230627 (03.11.2022 Gazette 2022/44)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: 26.04.2021 JP 2021074172

(71) Applicant: **Hitachi, Ltd.**
**Tokyo 100-8280 (JP)**

(72) Inventor: **PAOLETTI Umberto**
**Tokyo 100-8280 (JP)**

(74) Representative: **Mewburn Ellis LLP**
**Aurora Building**
**Counterslip**
**Bristol BS1 6BX (GB)**

(54) **ELECTROMAGNETIC NOISE MEASUREMENT METHOD AND ELECTROMAGNETIC NOISE MEASUREMENT DEVICE**

(57) Provided are a method for measuring an electromagnetic noise and an electromagnetic noise measurement device enabling accurate identification of a noise source. The method for measuring an electromagnetic noise performs a step for performing far-field measurement, at a first timing, in the vicinity of an object device, via a first port of a measurement probe, for measuring an electromagnetic noise in the vicinity of the object device, and storing measurement data thereof in a memory. After that, the method repetitively repeats, while changing measurement positions: a step for performing near-field measurement, at a second timing after the first timing, in the vicinity of a candidate of noise source that gives an electromagnetic noise to the object device, via the first port; and a step for calculating a noise source matching index, which is a numerical value indicating similarity between the far-field measurement and the near-field measurement.

Fig. 1

EP 4 332 589 A1

**Description**

Technical Field

The present invention relates to a method for measuring electromagnetic noise and an electromagnetic noise measurement device.

Background Art

It is required to suppress electromagnetic noises (or EM noises), such as an electromagnetic radiation noise, a conduction noise, or the like emitted from electronic circuit or the like , within a range of predetermined regulation value. If an electromagnetic noise is beyond the range of the regulation value, such an electromagnetic may affect operations in other circuits nearby. Accordingly, a technique for identifying a noise source generating an electromagnetic noise beyond the predetermined regulation value is needed.

As conventional measurement methods for identifying the noise source, known are a method for obtaining a frequency spectrum by frequency domain measurement and a method for obtaining the frequency spectrum by performing time-domain measurement and performing short-time Fourier transformation (ST-FFT). It is easy to identify a high-frequency noise source (for example, a noise from a clock signal circuit, a communication circuit, etc.) from the frequency spectrum.

However, conventional methods have a problem that, when measurement of an electromagnetic noise in the vicinity of an object device (far-field measurement) and measurement of an electromagnetic noise in the vicinity of a candidate of a noise source (near-field measurement) are performed to analyze the frequency spectrum, a measurement probe for performing the near-field measurement affects a measurement probe for the far-field measurement performed at the same time, thereby making accurate identification of the noise source difficult.

Citation List

Patent Literature

Patent Literature 1: JP 2014-222215 A

Summary of Invention

Technical Problem

An object of the present invention is to provide a method for measuring an electromagnetic noise and an electromagnetic noise measurement device that enable accurate identification of the noise source.

Solution to Problem

In order to solve the above problem, a method for measuring an electromagnetic noise related to the present invention performs a step for performing far-field measurement, at a first timing, via a first port, for measuring an electromagnetic noise in the vicinity of an object device, and storing measurement data thereof in a memory. After that, the method repetitively repeats, while changing measurement positions: a step for performing near-field measurement, at a second timing after the first timing, in the vicinity of a candidate of noise source that gives an electromagnetic noise to the object device, via the first port; and a step for calculating a noise source matching index, which is a numerical value indicating similarity between the far-field measurement and the near-field measurement.

Advantageous Effects of Invention

According to the present invention, a method for measuring an electromagnetic noise and an electromagnetic noise measurement device that enable accurate identification of the noise source are provided.

Brief Description of Drawings

FIG. 1 is a block diagram describing an electromagnetic noise measurement device 1501 related to a first embodiment.

FIG. 2 is a flowchart describing an operation (a method for measuring an electromagnetic noise) of the electromagnetic noise measurement device 1501 of the first embodiment.

FIG. 3A is a flowchart describing a calculation method for a noise source matching index NSMI.

FIG. 3B is a flowchart describing a calculation method for a noise source matching index NSMI in the first embodiment.

FIG. 4 is a flowchart describing a calculation method for a noise source matching index NSMI in a second embodiment.

FIG. 5 is a flowchart describing a calculation method for a noise source matching index NSMI in the second embodiment.

FIG. 6 is a flowchart describing a calculation method for a noise source matching index NSMI in a third embodiment.

FIG. 7 is a flowchart describing a calculation method for a noise source matching index NSMI in the third embodiment.

FIG. 8 shows an example of modulation frequency data 801 related to a detection signal of far-field measurement.

FIG. 9 shows an example of modulation frequency data 901 related to a detection signal of near-field measurement.

FIG. 10 is a graph indicating a frequency at which the maximum modulation amplitude (after normalization) is obtained in the modulation frequency data of FIG. 9.

FIG. 11 is a flowchart describing a calculation method for a noise source matching index NSMI in a fourth embodiment.

FIG. 12 shows an example of a waveform of a normalized frequency spectrum in the fourth embodiment.

Description of Embodiments

Present embodiments will be described below with reference to the attached drawings. In the drawings, functionally identical elements may be indicated with an identical number. Although the attached drawings illustrate embodiments and implementations in accordance with principle of the present disclosure, they are merely for understanding of the present disclosure and should not be used to interpret the present disclosure in a limiting way. Descriptions in the present specification are no more than typical examples and do not limit the claims or application of the present disclosure in any sense.

In the embodiments, descriptions are made in sufficient details so that those skilled in the art can implement the present disclosure. However, it should be understood that other implementations or embodiments are possible and changes in configuration and structure and replacement of various elements are possible without departing from the scope and spirit of the disclosed technical idea. Accordingly, the following descriptions must not be interpreted to be limited thereto.

Examples of various information may be explained with expressions such as "data", "graph", or the like. However, the various information may be expressed by other data structures. For example, various information such as "XX table", "XX list", "XX queue", etc. may be "XX information". Upon explaining about identification information, expressions such as "identification information", "identifier", "name", "ID", "number", etc. are used, but they are exchangeable with each other. If there are a plurality of components having the same function or similar functions, they may be explained by adding different indices to a same symbol. Also, if the plurality of components do not have to be distinguished, the indices may be omitted in explanation.

In implementation examples, a process performed by executing a program may be described. Here, a computer executes a program by a processor (for example, a CPU or a GPU) and performs a process defined by the program while using a storage resource (for example, a memory) and an interface device (for example, a communication port). Accordingly, an agent of the process performed by executing the program may be a processor. Similarly, the agent of the process performed by executing the program may be a controller, a device, a system, a computer, or a node, having a processor. The agent of the process performed by executing the program may be a calculation unit and may include a dedicated circuit for performing a specific process. Here, a dedicated circuit includes, for example, an FPGA (Field Programmable Gate Array) , an ASIC (Application Specific Integrated Circuit), a CPLD (Complex Programmable Logic Device), etc.

The program may be installed from a program source to a computer. The program source may be, for example, a program distribution server or a computer-readable storage medium. If the program source is a program distribution server, the program distribution server may include a processor and a storage resource for storing the program to be distributed, and the processor of the program distribution server may distribute the program to be distributed to another computer. Also, in an implementation example, two or more programs may be realized as a single program and a single program may be realized as two or more programs.

[First Embodiment]

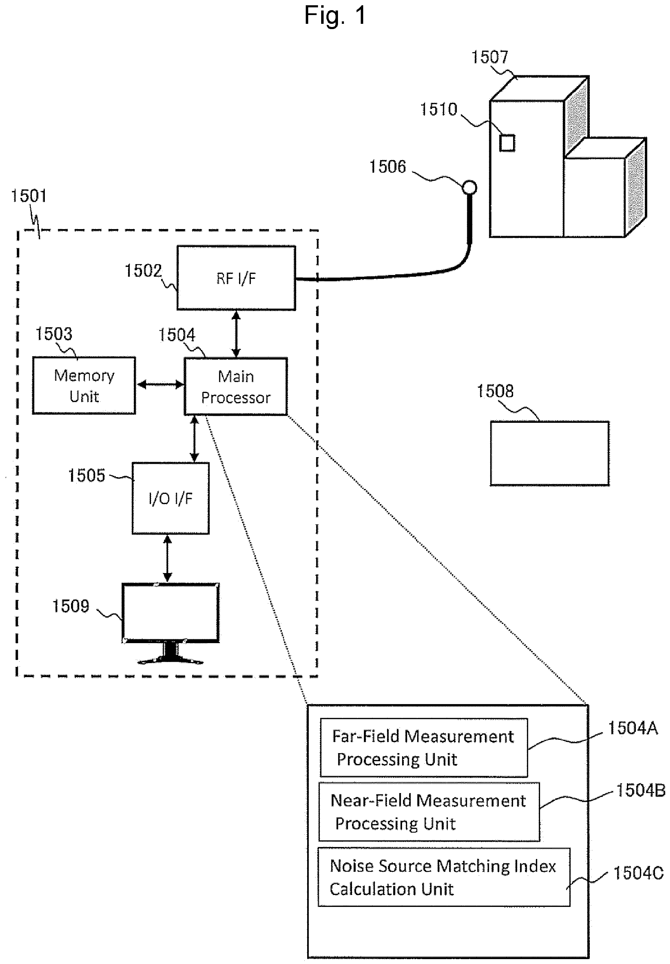

An electromagnetic noise measurement device 1501 according to a first embodiment will be described with reference to FIG.1. The electromagnetic noise measurement device 1501 is a device for identifying a noise source 1510 inside a target device 1507 with respect to an object device 1508 (Victim). In FIG. 1, only one noise source 1510 is shown. The number, position, etc. of the noise source 1510 are unknown before the start of measurement, and a user of the electromagnetic noise measurement device 1501 moves a measurement probe 1506 to various places (in the vicinity of the device that is a candidate of noise source). According to the obtained detection signal, a noise source that emits an electromagnetic noise that affects operation of the object device 1508 is identified. Here, the electromagnetic noise (or EM noise) is, for example, an electromagnetic radiation noise, a conduction noise, or the like emitted from an electronic circuit or the like.

As an example, the noise source measurement device 1501 is configured by comprising an RF interface 1502, a memory unit 1503, a main processor 1504, the measurement probe 1506, an I/O interface 1505, and a display 1509. The measurement probe 1506 is moved close to the device that is a candidate of the noise source 1510, and measures the electromagnetic noise at that position. The RF interface 1502 has a function of converting the detection signal detected by the measurement probe 1506 into a signal for processing at the main processor 1504 and transferring the signal.

The main processor 1504 constitutes a far-field measurement processing unit 1504A, a near-field measurement processing unit 1504B, and a noise source matching index calculation unit 1504C, which are realized by a computer program stored in the memory unit 1503. The far-field measurement processing unit 1504A performs measurement of an electromagnetic noise in a region (far field) which is in the vicinity of the object device 1508 and far from the noise source 1510. Further, the near-field measurement processing unit 1504B performs measurement of an electromagnetic noise in a region (near-field) which is in the vicinity of the device that is a candidate of the noise source 1510. The measurement by the far field measurement processing unit 1504A and the measurement by the near field measurement processing unit 1504B are executed at respectively different timings, and are performed in accordance with the detection signals inputted to the RF interface 1502 via a single port. The measurement by the far-field measuring unit 1504A precedes the measurement by the near-field measuring unit 1504B in time.

The noise source matching index calculation unit 1504C performs matching between the measurement data in the far-field measurement processing unit 1504A and the measurement data in the near-field measurement processing unit 1504B, and calculates a noise source matching index NSMI according to the matching result. The noise source matching index NSMI numerically indicates likelihood of electromagnetic noise affecting the operation of the object device 1508. That is, the larger the calculated value of the noise source matching index NSMI, the more likely it is that the device positioned in the vicinity of the measurement probe 1506 when the near field measurement processing unit 1504B is executed is determined to be the noise source.

The I/O interface 1505 is an interface for outputting data processed by the main processor 1504 to the display device 1509 or another external device (not shown) or receiving data from the external device or commands from the user. The display 1509 is configured to be able to display the data calculated by the main processor 12. The external device may be, for example, an input device (for example, a keyboard, a mouse, etc.) for the user to input a command (instruction), an external storage device, or a management device connected via a network. The display device 1509 may be a head-mounted display.

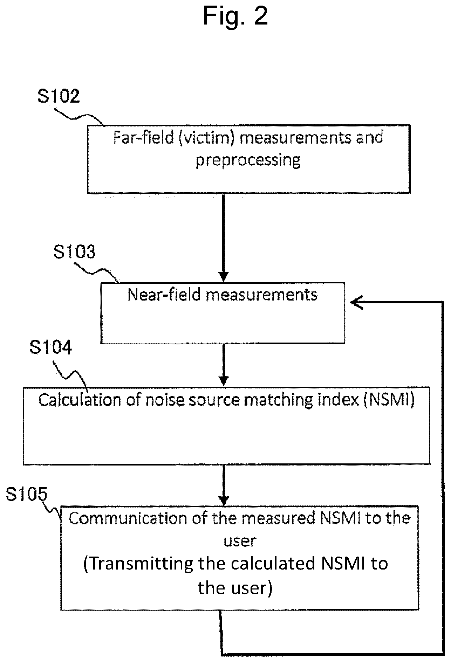

The operation (a method for measuring electromagnetic noise) of the electromagnetic noise measurement device 1501 of the first embodiment will be described with reference to FIG. 2. The electromagnetic noise measurement device 1501 of the first embodiment first performs far-field measurement in the vicinity of the object device 1508, and then, using the measurement probe 1506 and via the same port, performs the near-field measurement in the vicinity of a candidate of the noise source 1510. This makes it possible to accurately identify the noise source 1510 that affects the operation of the object device 1508.

First, in step S102, the far-field measurement and preprocessing are performed by the far-field measurement processing unit 1504A. The measurement data measured and preprocessed by the far-field measurement processing unit 1504A is temporarily held in the memory unit 1503.

Next, in step S103, the measurement probe 1506 is arranged in a region in the vicinity of the candidate of the noise source 1510 but spaced apart from the object device 1508, and the near-field measurement is performed by the near-field measurement processing unit 1504B. Step S103 is executed at a timing after step S102. The measurement data obtained by the near-field measurement processing unit 1504B is temporarily held in the memory unit 1503.

In the following step S104, the noise source matching index calculation unit 1504C calculates the noise source matching index NSMI based on the measurement data of the far-field measurement executed in step S102 and stored in the memory unit 1503 and the measurement data of the near-field measurement executed in step S103. The calculated noise source matching index NSMI is stored in the memory unit 1503 together with the time data and the like.

Then, in step S105, the calculated noise source matching index NSMI is transferred to the display device 1509 or the external device (not shown) via the I/O interface 1505, and notified to the user of the device. These steps S103 to S105 are repetitively executed while changing the positions (measurement positions) of the measurement probe 1506. The user confirms the noise source matching index NSMI displayed on the display device 1509 or transferred to the external device for each different position of the measurement probe 1506. Then, when a high value is obtained as the noise source matching index NSMI, the device positioned in the vicinity of the closest measurement probe 1506 can be determined as the noise source.

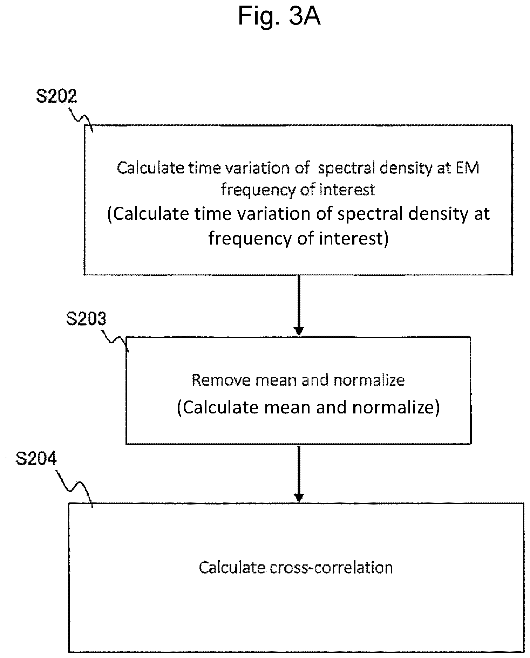

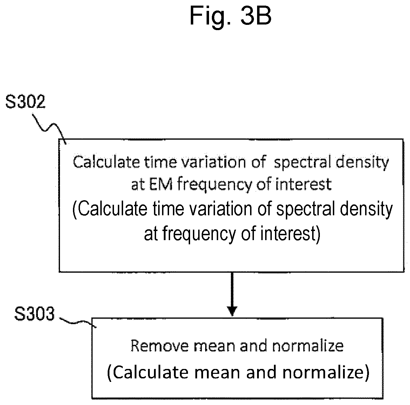

A calculation method for the noise source matching index NSMI in the first embodiment will be described with reference to the flowcharts of FIGs. 3A and 3B. In many cases, an electromagnetic noise has a certain periodicity when observed for a sufficiently long period (cyclo-stationarity). Therefore, an approximate temporal correlation can be expected between the measurement data of the far-field measurement and the measurement data of the near-field measurement.

By calculating the maximum of the absolute value of the cross-correlation between one time-dependent frequency of the measurement data of the far-field measurement and the same time-dependent frequency of the measurement data of the near-field measurement (deferred cross-correlation at the same frequency), the noise source matching index NSMI can be calculated. Specifically, as shown in FIG. 3A, time variation $\sigma_s[k,n]$ of a spectral density of the detection signal of the near-field measurement at the frequency index k of interest is calculated (Step S202). Meanwhile, time variation $\sigma_v[k,n]$ of a spectral density of the far-field measurement at the frequency index k of interest (the same frequency) is calculated as shown in FIG. 3B (step S302). The detection signal of the far-field measurement is stored in the memory unit 1503 after the measurement in step S102.

Then, in steps S203 and S303, average values $\overline{\sigma_s}$ and $\overline{\sigma_v}$ of $\sigma_s[k,n]$ and $\sigma_v[k,n]$ are calculated, and these average values $\overline{\sigma_s}[k]$ and $\overline{\sigma_v}[k]$ are subtracted from $\sigma_s[k,n]$ and $\sigma_v[k,n]$ to calculate signals $S_0[k,n]$ and $V_0[k,n]$ (the first and second equations of [Equation 1] below). Then, the signals $S_0$ and $V_0$ are normalized, the time interval m that maximizes the sum of the products of the normalized signals is searched, and the sum that is the maximum value is set as the cross-correlation value $I_d[k]$ (the third equation in [Equation 1]).

[Equation 1]

$$S_0[k,n] = \sigma_s[k,n] - \overline{\sigma_s}[k]$$

$$V_0[k,n] = \sigma_v[k,n] - \overline{\sigma_v}[k]$$

$$I_d[k] = \max_m \frac{\left|\sum_n V_0[k,n+m]\, S_0[k,n]\right|}{\|V_0[k]\|\,\|S_0[k]\|}$$

As described above, according to the electromagnetic noise measurement device of the first embodiment, the far-field measurement and the near-field measurement are performed via a single port at different times, and the noise source 1510 is identified by calculating the noise source matching index NSMI between the two. Therefore, since the measurement result of the far field measurement is not affected by the measurement probe at the time of the near field measurement, it becomes easy to perform the far field measurement more accurately and accurately identify the noise source.

[Second Embodiment]

Subsequently, an electromagnetic noise measurement device according to a second embodiment will be described with reference to FIGs. 1, 2, 4 and 5. Since the configuration of the electromagnetic noise measurement device is substantially the same as that of the first embodiment, redundant description will be omitted. Further, the method for determining the noise source is also the same as that of the first embodiment (FIG. 2). However, in this second embodiment, the calculation method for the noise source matching index NSMI is different from that in the first embodiment. Specifically, the second embodiment employs a method for analyzing the cross-correlation between the far-field measurement and the near-field measurement in different frequency regions (deferred cross-correlation at different frequencies), which is different from the first embodiment.

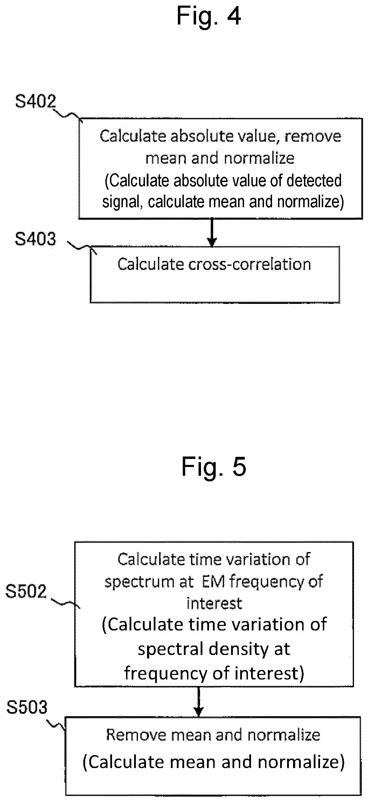

A procedure for executing the calculation of the noise source matching index NSMI of the second embodiment will be described with reference to the flowchart of FIG 4. This calculation method is effective when there is a wideband noise generated by low frequency switching.

In this second embodiment, the absolute value |s[n]| of the detection signal s[n] in the time domain of the low frequency region of the near field measurement is calculated as in the first equation of the following [Equation 2]. The signal $s_0[n]$ is generated by subtracting an average value $\overline{|s|}$ of the absolute values of the detection signals s[n] from the absolute values |s[n]| (step S402).

Regarding the far-field measurement, with reference to FIG. 5, and as in the second equation of [Equation 2], the square root of the time variation $\sigma_v[k,n]$ of the spectral density of one high frequency component k of the detection signal of the far field measurement is calculated (step S502). An average value of the square root is subtracted from the square root to calculate the signal $V_0[k,n]$ (step S503). Then, as in the third equation, the signals $s_0$ and $V_0$ are normalized, the time interval m which gives the maximum sum of the products of the normalized signals is searched, and the maximized sum will be the cross-correlation value $I_m[k]$ (step S403).

[Equation 2]

$$s_0[n] = |s[n]| - \overline{|s|}$$

$$V_0[k,n] = \sqrt{\sigma_v[k,n]} - \overline{\sqrt{\sigma_v}[k]}$$

$$I_m[k] = \max_m \frac{\left|\sum_n V_0[k,n+m]\, s_0[n]\right|}{\|V_0[k]\|\ \|s_0\|}$$

[Third Embodiment]

Subsequently, an electromagnetic noise measurement device according to a third embodiment will be described with reference to FIGs. 1, 2, 6 and 7. Since the configuration of the electromagnetic noise measurement device is substantially the same as that of the first embodiment, redundant description will be omitted. Further, the method for determining the noise source is also the same as that of the first embodiment (FIG. 2). However, in this third embodiment, the calculation method for the noise source matching index NSMI is different from that in the first embodiment. Specifically, it differs from the above-described embodiment in that the modulation frequency analysis (MFA) projection at the same frequency is executed in the calculation of the noise source matching index.

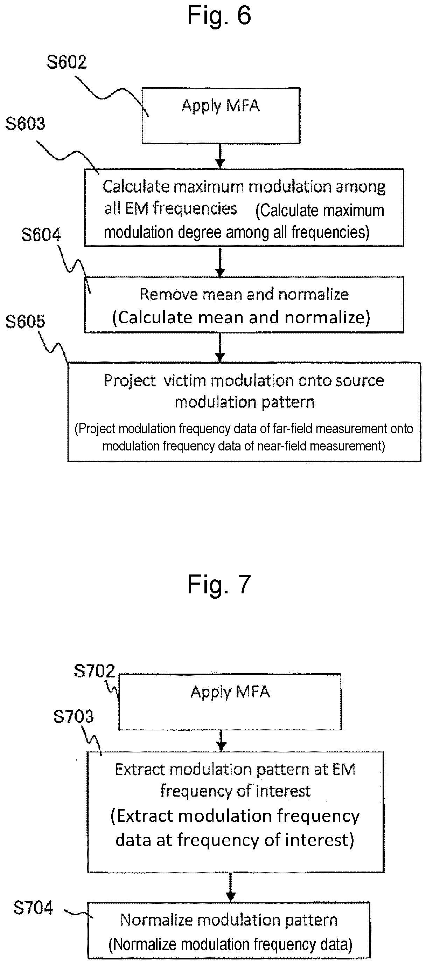

The procedure for processing the measurement result of the far-field measurement of S102 in FIG.2 for the third embodiment will be described with reference to FIG. 7. The modulation frequency analysis is applied to the detection signal in the time domain of the far field measurement. Next, the modulation frequency data $X_v[k,i]$ at the frequency k of interest is extracted for all modulation frequencies i (step S703) and a normalized modulation frequency pattern ^V[k, i] is obtained as in [Equation 3] (step S704).

[Equation 3]

$$\hat{V}[k,i] = \frac{|X_v[k,i]|}{\sqrt{\sum_i |X_v[k,i]|^2}}$$

The procedure for calculating the noise source matching index NSMI in the third embodiment will be described with reference to FIG. 6. First, in step S602, the modulation frequency analysis is applied to the detection signal in the time domain of the near-field measurement, and the modulation frequency data $X_{sL}[k,i]$ is calculated. Here, the modulation frequency data is information in which the frequency of the electromagnetic noise, the modulation frequency of the electromagnetic noise, and the intensity of the electromagnetic noise are associated with each other.

Subsequently, in step S603, the maximum modulation degree (modulation amplitude) $S_m[i]$ among all the frequencies in the modulation frequency data is calculated as in the first equation of the following [Equation 4]. Then, as in the second and third equations of [Equation 4], an average value $/S_m$ is subtracted from the maximum modulation degree $S_m[i]$ and normalization is performed (step S604).

[Equation 4]

$$S_m[i] = \max_k |X_s[k,i]|$$

$$S[i] = S_m[i] - \overline{S_m}$$

$$\hat{S}[i] = \frac{S[i]}{\|S\|}$$

Then, the normalized modulation frequency data ^V[k] of the far-field measurement thus obtained is projected onto the normalized modulation frequency data ^S of the near-field measurement (step S605). Specifically, as shown in [Equation 5], an absolute value of their dot product is calculated. The noise source matching index NSMI is calculated according to the result of this projection (the dot product).

[Equation 5]

$$\hat{P}[k] = \left| \hat{V}[k] \cdot \hat{S} \right|$$

Another procedure for calculating the noise source matching index NSMI in the third embodiment will be described with reference to Fig. 7. The modulation frequency analysis is applied to the detection signal in the time domain of the near-field measurement and the detection signal in the time domain of the far-field measurement to calculate the modulation frequency data (step S702) in a manner similar to FIG. 6. Next, the modulation frequency data at the frequency of interest is extracted from the both modulation frequency data (step S703). Then, the both modulation frequency patters are normalized (step S704) and projected in a similar manner to calculate the noise source matching index NSMI.

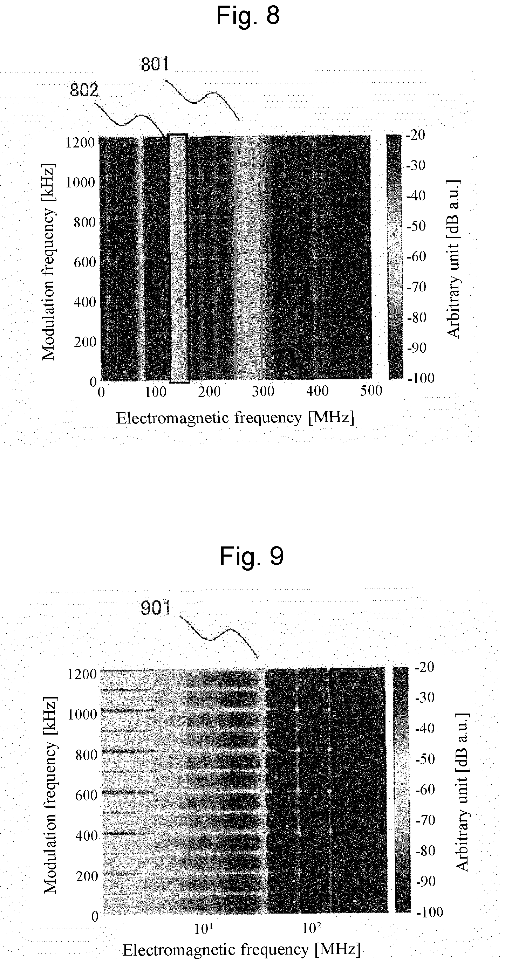

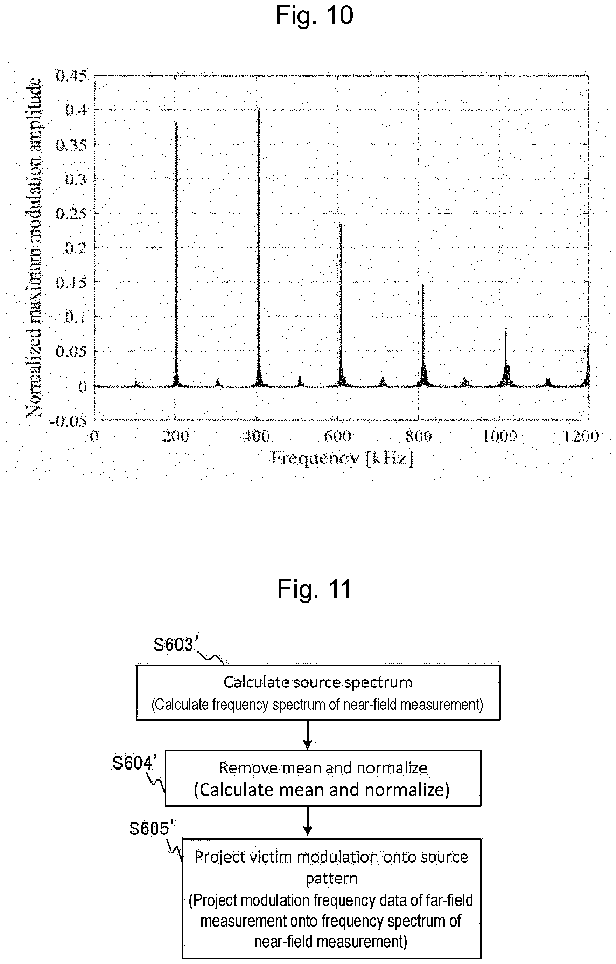

FIG. 8 is an example of the modulation frequency data 801 related to the detection signal of the far field measurement, and FIG. 9 is an example of the modulation frequency data 901 related to the detection signal of the near field measurement. In FIG. 8, reference numeral 802 indicates a modulation pattern (step S703) of frequency data related to the frequency of interest. FIG. 10 is a graph showing the frequency at which the maximum modulation amplitude (after normalization) is obtained in the modulation frequency data of FIG.9.

[Fourth Embodiment]

Subsequently, an electromagnetic noise measurement device according to the fourth embodiment will be described with reference to FIG. 11. Since the configuration of the electromagnetic noise measurement device is substantially the same as that of the first embodiment, redundant description will be omitted. Further, the method for determining the noise source is also the same as that of the first embodiment (FIG. 2). The method for processing he measurement result of the far-field measurement of the step S102 is similar to the third embodiment (FIG. 7). However, in this fourth embodiment, the calculation method for the noise source matching index NSMI is different from that in the first embodiment. Specifically, it differs from the above-described embodiment in that the modulation frequency analysis (MFA) projection at different frequency is performed in the calculation of the noise source matching index.

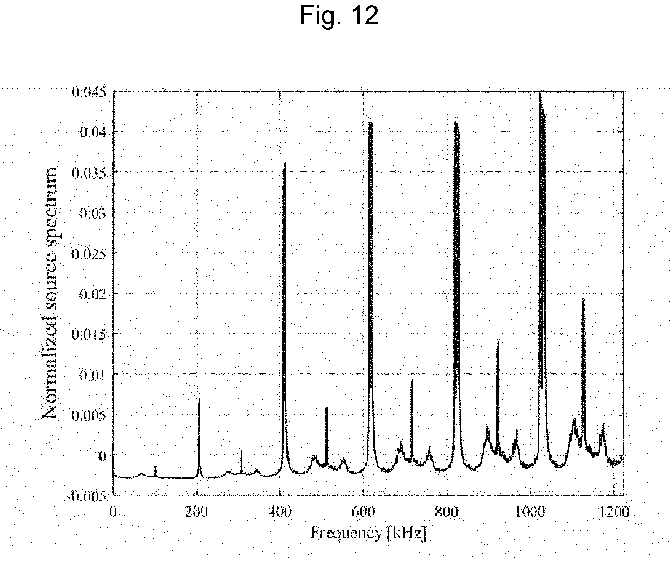

A procedure for calculating the noise source matching index NSMI in the fourth embodiment will be described with reference to FIG. 11. In this embodiment, the modulation frequency analysis is not applied to the detection signal in the time domain of the near-field measurement. A frequency spectrum $S_p[i]$ of the detection signal $\sigma_s$ in the time domain of the near-field measurement is measured, for example, by estimating a power spectral density using a Fourier transform of the waveform measured by an oscilloscope (not shown), or by using a spectrum analyzer (step S603'). Then, an average value $/S_p$ is subtracted from the frequency spectrum $S_p[i]$ and normalization is performed (step S604'). FIG. 12 is an example of a waveform of the normalized frequency spectrum. Then, the modulation frequency data of the far-field measurement is projected onto the frequency spectrum of the near-field measurement (step S605). As a result of the projection, the noise source matching index NSMI is calculated according to similarity between both data.

The present invention is not limited to the above-described embodiments, and includes various modifications. For example, the above-described embodiments have been described in detail in order to facilitate understanding of the present invention, and are not necessarily limited to ones including all the described configurations. Further, it is possible to replace a part of the configuration of one embodiment with the configuration of another embodiment, and it is also possible to add the configuration of an embodiment to the configuration of another embodiment. Further, it is possible to add / delete / replace other configurations with respect to a part of the configurations of each embodiment.

Further, each of the above configurations, functions, processing units, processing means, etc. may be realized by hardware by designing a part or all of them by, for example, an integrated circuit. Further, each of the above configurations, functions, and the like may be realized by software by the processor interpreting and executing a program that realizes each function. Information such as programs, tables, and files that realize each function can be placed in a memory, a hard disk, a recording device such as an SSD (Solid State Drive), or a recording medium such as an IC card, an SD card, or a DVD.

Reference Signs List

1501    Electromagnetic noise measurement device
1502    RF interface
1503    Memory unit
1504    Main processor
1505    I/O interface
1506    Measurement probe
1507    Target device
1508    Object device
1510    Noise source
1509    Display


**Claims**

1.  A method for measuring electromagnetic noise, comprising:

    a step for performing far-field measurement, at a first timing, via a first port, for measuring an electromagnetic noise in the vicinity of an object device, and storing measurement data thereof in a memory; and after that, repetitively performing, while changing measurement positions:

    a step for performing near-field measurement, at a second timing after the first timing, in the vicinity of a candidate of noise source that gives an electromagnetic noise to the object device, via the first port; and
    a step for calculating a noise source matching index, which is a numerical value indicating similarity between the far-field measurement and the near-field measurement.

2.  The method according to claim 1, further comprising a step for presenting the noise source matching index to a user.

3.  The method according to claim 1, wherein the step for calculating the noise source matching index includes:

    calculating time variation of a spectral density of a detection signal of the far-field measurement at a frequency index k of interest;
    calculating time variation of a spectral density of a detection signal of the near-field measurement at the frequency index k of interest;
    calculating a signal obtained by subtracting an average value of the time variation of the spectral density from the time variation of the spectral density, and normalizing the signal; and
    calculating a maximum of cross-correlation between two normalized signals.

4.  The method according to claim 1, wherein the step for calculating the noise source matching index includes:

    calculating an absolute value of a detection signal in a time domain of a first frequency region of the far-field measurement, and calculating a first signal obtained by subtracting an average value of the absolute value of the detection signal from this absolute value;
    Calculating a square root of time variation of a spectral density of a frequency component of a second frequency region on a higher frequency side with respect to the first frequency region in the near-field measurement, and calculating a second signal by subtracting an average value of the square root from the square root; and
    normalizing the first signal and the second signal, searching for a time interval at which a sum of products of the normalized signals becomes maximum, and outputting the sum of the products at that time as a cross-correlation value.

5.  The method according to claim 1, wherein the step for calculating the noise source matching index includes:

    applying modulation frequency analysis to a detection signal in a time domain of the near-field measurement and a detection signal in a time domain of the far-field measurement to calculate modulation frequency data;
    calculating near-field modulation frequency pattern that gives a maximum modulation degree among all frequencies in the modulation frequency data, subtracting an average value thereof from the modulation frequency data, and performing normalization; and
    projecting the modulation frequency data of the far-field measurement onto the modulation frequency pattern of the near-field measurement and calculating the noise source matching index according to a result of the projection.

6. The method according to claim 1, wherein the step for calculating the noise source matching index includes:

measuring a frequency spectrum of a detection signal in a time domain of the near-field measurement;
applying modulation frequency analysis to a detection signal in a time domain of the far-field measurement to calculate modulation frequency data;
projecting the modulation frequency data of the far-field measurement onto frequency spectrum data of the near-field measurement and calculating the noise source matching index according to a result of the projection.

7. An electromagnetic noise measurement device comprising:

a measurement probe for measuring an electromagnetic noise in the vicinity of an object device and in the vicinity of a noise source; and
a computer system connected to the measurement probe via a first port,
wherein the computer system is configured to:

perform far-field measurement, at a first timing, in the vicinity of the object device, via the first port of the measurement probe, for measuring an electromagnetic noise in the vicinity of the object device, and store measurement data thereof in a memory;
perform near-field measurement, at a second timing after the first timing, in the vicinity of a candidate of the noise source, via the first port, for measuring an electromagnetic noise in the vicinity of the candidate of the noise source; and
calculate a noise source matching index, which is a numerical value indicating similarity between the far-field measurement and the near-field measurement.

8. The electromagnetic noise measurement device according to claim 7, further comprising a display unit that displays the noise source matching index to a user.

# Fig. 1

Far-Field Measurement Processing Unit — 1504A

Near-Field Measurement Processing Unit — 1504B

Noise Source Matching Index Calculation Unit — 1504C

# Fig. 2

S102

Far-field (victim) measurements and preprocessing

S103

Near-field measurements

S104

Calculation of noise source matching index (NSMI)

S105

Communication of the measured NSMI to the user
(Transmitting the calculated NSMI to the user)

# Fig. 3A

S202

Calculate time variation of spectral density at EM
frequency of interest
(Calculate time variation of spectral density at
frequency of interest)

S203

Remove mean and normalize
(Calculate mean and normalize)

S204

Calculate cross-correlation

# Fig. 3B

S302

Calculate time variation of spectral density
at EM frequency of interest
(Calculate time variation of spectral density
at frequency of interest)

S303

Remove mean and normalize
(Calculate mean and normalize)

# Fig. 4

S402

Calculate absolute value, remove
mean and normalize
(Calculate absolute value of detected
signal, calculate mean and normalize)

S403

Calculate cross-correlation

# Fig. 5

S502

Calculate time variation of
spectrum at EM frequency of
interest
(Calculate time variation of
spectral density at
frequency of interest)

S503

Remove mean and normalize
(Calculate mean and normalize)

# Fig. 6

S602

Apply MFA

S603

Calculate maximum modulation among all EM frequencies    (Calculate maximum modulation degree among all frequencies)

S604

Remove mean and normalize
(Calculate mean and normalize)

S605

Project victim modulation onto source modulation pattern

(Project modulation frequency data of far-field measurement onto modulation frequency data of near-field measurement)

# Fig. 7

S702

Apply MFA

S703

Extract modulation pattern at EM frequency of interest
(Extract modulation frequency data at frequency of interest)

S704

Normalize modulation pattern
(Normalize modulation frequency data)

## Fig. 8

## Fig. 9

## Fig. 10

## Fig. 11

# Fig. 12

## INTERNATIONAL SEARCH REPORT

| | International application No. |
|---|---|
| | **PCT/JP2022/017225** |

### A. CLASSIFICATION OF SUBJECT MATTER

**G01R 29/08**(2006.01)i
FI: G01R29/08 D

According to International Patent Classification (IPC) or to both national classification and IPC

### B. FIELDS SEARCHED

Minimum documentation searched (classification system followed by classification symbols)

G01R29/08-29/10

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

IEEE Xplore

### C. DOCUMENTS CONSIDERED TO BE RELEVANT

| Category* | Citation of document, with indication, where appropriate, of the relevant passages | Relevant to claim No. |
|---|---|---|
| X | WO 2020/255527 A1 (HITACHI, LTD.) 24 December 2020 (2020-12-24) paragraphs [0015]-[0038], [0054]-[0057], fig. 1-4, 8-10 | 1-2, 7-8 |
| A | | 3-6 |
| A | 鈴木聡,金田泰昌,佐野宏靖,佐々木秀勝. 非負値行列因子分解を用いたスイッチング ノイズ源識別手法の開発. 令和3年電気学会全国大会講演論文集　一般講演 1 . 01 March 2021, pp. 30, 31, (SUZUKI, Satoshi, KANEDA, Yasuaki, SANO, Hiroyasu, SASAKI, Hidekatsu. Switching noise source separation from radiated emission using Nonnegative Matrix Factorization), non-official translation (Proceedings of the 2021 Annual Meeting IEE of Japan 2021.) in particular, see 4. Experiment, fig. 1 | 1-8 |
| A | PAOLETTI, Umberto. Broadband Electromagnetic Noise Source Identification Using Modulation Frequency Analysis. 2020 International Symposium on Electromagnetic Compatibility - EMC EUROPE. 23 September 2020, DOI: 10.1109/EMCEUROPE48519.2020.9245870 entire text | 1-8 |

☑ Further documents are listed in the continuation of Box C.    ☑ See patent family annex.

| | | |
|---|---|---|
| * | Special categories of cited documents: | "T"   later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X"   document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&"   document member of the same patent family |
| "P" | document published prior to the international filing date but later than the priority date claimed | |

| Date of the actual completion of the international search | Date of mailing of the international search report |
|---|---|
| **14 June 2022** | **21 June 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

International application No.

**PCT/JP2022/017225**

**C.    DOCUMENTS CONSIDERED TO BE RELEVANT**

| Category* | Citation of document, with indication, where appropriate, of the relevant passages | Relevant to claim No. |
|---|---|---|
| A | FENG, Gang, WU, Wei, POMMERENKE, David, FAN, Jun, BEETNER, Daryl G. Time Synchronized Near-field and Far-field for EMI Source Identification. 2008 IEEE International Symposium on Electromagnetic Compatibility. 18 August 2008, DOI: 10.1109/ISEMC.2008.4652142<br>        entire text | 1-8 |
| P, X | PAOLETTI, Umberto. Deferred time-frequency cross-correlation for EM source determination with one-port measurements. 2021 IEEE International Joint EMC/SI/PI and EMC Europe Symposium. 26 July 2021, DOI: 10.1109/EMC/SI/PI/EMCEurope52599.2021.9559273<br>        in particular, see II. PROPOSED MEASUREMENT METHODS | 1-2, 7-8 |

Form PCT/ISA/210 (second sheet) (January 2015)

**INTERNATIONAL SEARCH REPORT**
Information on patent family members

International application No.

**PCT/JP2022/017225**

| Patent document cited in search report | | | Publication date (day/month/year) | Patent family member(s) | | | Publication date (day/month/year) |
|---|---|---|---|---|---|---|---|
| WO | 2020/255527 | A1 | 24 December 2020 | EP 3988949 A1 paragraphs [0015]-[0038], [0059]-[0063], fig. 1-4, 8-10 | | | |
| | | | | CN | 113785208 | A | |
| | | | | JP | 2020-204561 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014222215 A